# FASCICULE DE BREVET EUROPEEN

(11) **EP 0 321 340 B1**
(45) Date de publication et mention de la délivrance du brevet: **13.01.1993**
(21) Numéro de dépôt: 88403177.4
(22) Date de dépôt: 14.12.1988
(51) Int. Cl.: G06K 19/06, H01L 23/50

(54) **Support de composant électronique, notamment pour carte mémoire, et produit ainsi obtenu**
Halter für elektronische Komponenten, insbesondere für Speicherkarten und auf solche Weise hergestelltes Produkt
Electronic-component support, especially for a memory card, and product so obtained

(30) Priorité: 14.12.1987 FR 8717385
(43) Date de publication de la demande: 21.06.1989
(73) Titulaire: SGS-THOMSON MICROELECTRONICS S.A., 94250 Gentilly (FR)
(72) Inventeur: Gloton, Jean-Pierre, F-75116 Paris (FR); Peres, Philippe, F-75116 Paris (FR)
(74) Mandataire: Ballot, Paul Denis Jacques

(56) Documents cités:
- EP-A- 0 211 360
- EP-A- 0 231 937
- EP-A- 0 246 973
- FR-A- 2 547 457
- FR-A- 2 583 574
- PATENT ABSTRACTS OP JAPAN, vol. 8, no. 204 (P-301)[1641], 18 septembre 1984; & JP-A-59 90 183 (SONY K.K.) 24-05-1984

## Description

L'invention concerne, d'une manière générale les supports de composant électronique et, plus particulièrement les cartes mémoire qui comportent au moins un composant électronique actif qui est logé dans une cavité de ladite carte et qui est monté sur un support.

Il est courant d'utiliser des cartes d'identification dans de nombreux domaines, notamment dans celui des cartes bancaires ou de crédit. Pendant très longtemps, ces cartes ne comportèrent, outre un numéro d'identification et le nom du titulaire, qu'un enregistrement magnétique qui en permettait l'identification par lecture magnétique. Depuis quelques années, ces cartes sont utilisées à d'autres fonctions que l'identification du titulaire et, en particulier, à des fins de pré-paiement et de protection contre les actions des fraudeurs. A cet effet, la carte comporte un composant électronique actif qui peut être constitué d'une mémoire électronique associée ou non à un microprocesseur, ce qui permet de l'utiliser notamment pour des applications de type bancaire.

De telles cartes sont connues des documents FR-A-2583 574, FR-A-2547 457, JP-A-5 990 183, EP-A-0211 360.

Les cartes de crédit de cette technique, qui comportent un composant électronique, sont fabriquées de diverses manières. Selon un premier procédé, une cavité est aménagée dans l'épaisseur de la carte pour recevoir le composant électronique. Selon un autre procédé, dit de "co-laminage", on lamine de fines couches de matière plastique : polyépoxy, polyéthylène, polychrome de vinyl et.... autour du composant. Lors de la mise en oeuvre de ces procédés, diverses opérations sont en outre effectuées pour assurer la connexion électrique des bornes du composant électronique à des métallisations qui sont disposées en surface sur la carte.

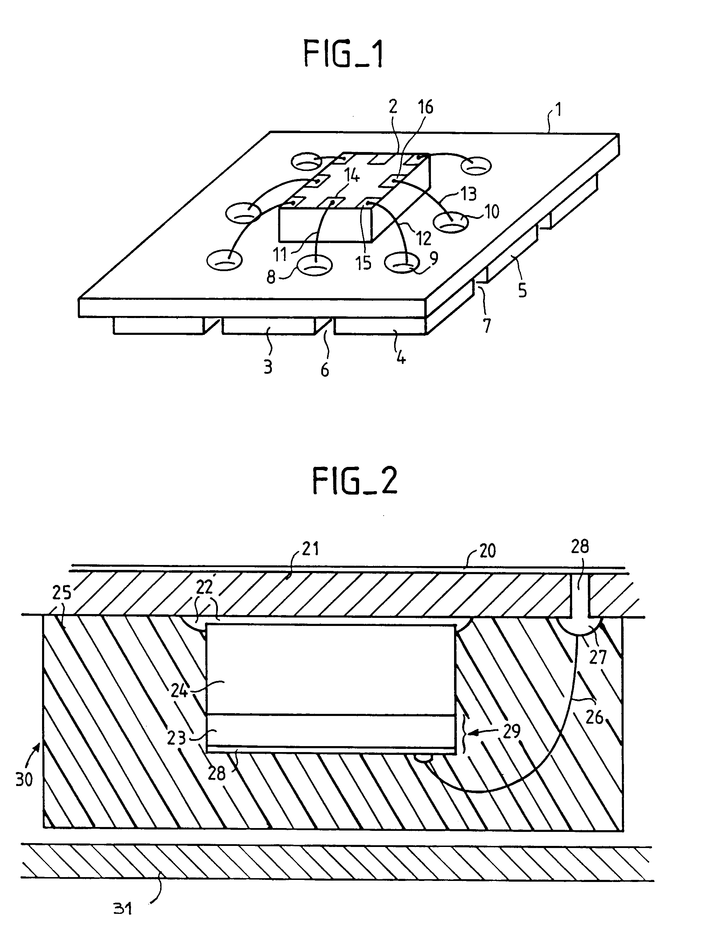

L'un des procédés pour mettre en place le composant électronique dans la cavité aménagée dans la carte et pour disposer les métallisations sur la carte ainsi que pour réaliser les connexions entre les bornes de la carte et les métallisations, consiste, comme le montre la figure 1, à utiliser un film 1 non conducteur, par exemple en polyépoxy, qui porte d'un côté le composant électronique sous forme d'une "puce" (référence 2) et de l'autre côté des surfaces métallisées, telles que celles référencées 3,4 et 5, et séparées les unes des autres par des espaces 6 et 7 sans métallisation. Ces surfaces métallisées 3,4 et 5 communiquent avec l'autre côté du film 1 par des trous 8,9 et 10 par l'intermédiaire desquels les extrémités des fils conducteurs 11, 12 et 13 viennent se connecter aux surfaces métallisées correpondantes par tout moyen connu, tel qu'une colle conductrice. L'autre extrémité de chaque fil conducteur est connectée à une borne de sortie 14, 15 ou 16 de la puce 2.

Ces opérations sont ensuite suivies de l'enrobage de la puce 2 avec de la résine et d'une cuisson de la résine pour obtenir l'encapsulation de la puce. On peut alors mettre en place la puce dans la cavité de la carte et disposer les métallisations sur les bords de la cavité par simple emboîtage de la puce et collage du film support 1 sur la carte après son découpage aux dimensions requises.

Un tel procédé conduit à une structure dans laquelle la puce 2 est collée au film 1, auquel adhère une couche de zones métalliques. L'ensemble film-couche métallique est relativement souple, plus souple que la carte en polyépoxy, alors que la puce, dont la base est un socle de silicium d'une épaisseur de plusieurs centaines de microns (par exemple 280 microns) est rigide, dure et cassante. Il en résulte des contraintes, notamment lorsque la carte d'identification est manipulée sans précaution, contraintes qui aboutissent à des cassures du socle de silicium et donc à la destruction de la puce.

Une solution à ce problème consiste à augmenter l'épaisseur du socle de silicium, mais on est limité par la profondeur de la carte. En outre, une épaisseur plus grande augmente bien entendu la résistance mécanique générale de la puce, mais cette dernière reste fragile aux chocs.

Un but de la présente invention est donc de réaliser un support de composant électronique qui remédie aux inconvénients précités, sans augmentation de l'épaisseur du composant final, et qui protège le composant électronique contre les détériorations mécaniques, dues, notamment, à des manipulations violentes de la carte dans laquelle le composant est logé.

Ce problème de la tenue mécanique du substrat de silicium se pose également dans d'autres domaines que celui des cartes à mémoire, notamment lorsque le composant électronique est utilisé dans un environnement soumis aux chocs et aux vibrations par exemple dans le domaine des automobiles, des aéronefs etc...

Par ailleurs, le composant électronique, par suite de la puissance dissipée dans les circuits électroniques peut avoir tendance à s'échauffer de sorte que la chaleur doit être dissipée dans le socle ou substrat de silicium. Or le silicium est un matériau dont la capacité de dissipation thermique n'est pas très élevée et n'est donc pas un radiateur très efficace.

Un autre but de la présente invention est également réaliser un support de composant électronique qui puisse dissiper de manière efficace la chaleur générée par le composant électronique.

L'invention concerne un support de composant électronique pour carte mémoire qui comporte une cavité pour le logement dudit composant, le support comprenant un premier socle de silicium d'épaisseur comprise entre 50 à 100 microns dont un côté sert de base à la fabrication des différents éléments du composant électronique proprement dit et un deuxième socle d'épaisseur comprise entre 100 et 300 microns en un matériau moins cassant que le silicium, ledit socle ayant une épaisseur plus grande que celle du premier socle et une section identique à celle du premier socle et étant fixé de l'autre côté du premier socle ainsi que sur le premier film qui sert d'élément de fermeture de la cavité.

L'invention se rapporte également à une carte à mémoire munie d'une cavité comportant un composant électronique qui repose sur un tel support selon l'invention.

D'autres caractéristiques et avantages de la présente invention apparaîtront à la lecture de la description suivante d'un exemple particulier de réalisation, ladite description étant faite en relation avec le dessin joint dans lequel :
- la figure 1 est une vue en perspective cavalière d'un film de support de composant électronique et de ses connexions électriques selon l'art antérieur;
- la figure 2 est une vue en coupe partielle d'une carte d'identification comportant une cavité dans laquelle est logé le composant électronique selon l'invention.

La figure 1 correspond à l'art antérieur et a été décrite dans le préambule. La coupe schématique de la figure 2 montre un composant électronique 29 comportant un socle en silicium à partir duquel sont réalisées les différentes couches 28 pour obtenir les différents composants du circuit.

Selon l'art antérieur, l'épaisseur du socle 23 est d'environ trois cents microns et ce socle est fixé sur un film support 21 par une couche de colle. Le côté du film 21, opposé à celui du composant électronique, porte une couche métallique 20 qui est divisée en zones de contact comme celles référencées 3 et 4 sur la figure 1. Cette structure de l'art antérieur est fragile, car le socle de silicium est directement en contact avec le film souple 21, à la couche de colle près ; il peut en résulter des cassures du socle et donc une détérioration complète du composant électronique. Une solution évidente à ce problème est d'augmenter l'épaisseur du socle, mais on est limité dans cette voie car le composant et sa capsule de protection 25 ne peuvent dépasser, ensemble, une épaisseur de six cents microns environ, ce qui est la profondeur de la cavité de la carte de support.

Aussi, selon la présente invention, il est proposé de diminuer sensiblement l'épaisseur du socle ou substrat de silicium 23 et de remplacer l'épaisseur enlevée par un deuxième socle en un matériau ayant une meilleure résistance mécanique et thermique que celle du silicium. De manière plus précise, l'épaisseur du silicium est ramenée à cinquante microns et le reste du socle (deux cents à deux cent cinquante microns) est constitué par des matériaux métalliques tels que le cuivre, le titane, le cobalt, le vanadium, le béryllium, l'argent etc...On peut également utiliser des matériaux non métalliques tels qu'une céramique ou encore un plastique chargé en fibres de verre ou en matériaux métalliques.

Pour réaliser ce nouveau socle, on part d'un socle ou substrat de silicium ayant une épaisseur de cinquante microns sur lequel on dépose, par tout procédé connu (par exemple par dépôt sous vide), le matériau durcisseur de la structure. De préférence, ce matériau durcisseur est également bon dissipateur de la chaleur.

C'est avec ce nouveau socle que toutes les opérations de diffusion et de dépôt sont effectuées dans la couche de silicium 23 amincie pour obtenir le composant électronique.

Le composant électronique est ensuite fixé par sa base 24 sur le film 21 par une couche de colle 22. Chaque borne de sortie du composant, côté silicium, est ensuite connectée par un fil conducteur 26 et une soudure 27 à une zone de contact de la couche métallique 20, au travers d'un trou 28 du film 21. L'opération suivante consiste à encapsuler le composant électronique et les fils conducteurs dans une résine 25 de manière à protéger l'ensemble. Après cette opération, le tout (composant encapsulé-film support-couche métallique) est mis en place dans la cavité (30) de la carte prévue à cet effet, cette cavité étant fermée par un fond 31 qui fait partie intégrante de la carte. Ce deuxième socle 24, en un matériau dur, permet de protéger le premier socle 23 en silicium sans augmenter l'épaisseur de la structure. En outre, il permet de dissiper la chaleur générée par le composant électronique.

L'invention a été décrite en supposant que le composant électronique était fixé sur un film support, mais elle s'applique aussi dans le cas où le film support n'est pas utilisé.

## Revendications

1. Support de composant électronique pour carte mémoire qui comporte une cavité pour le logement dudit composant, caractérisé en ce que le support comprend un premier socle de silicium (23) d'épaisseur comprise entre 50 à 100 microns dont un côté sert de base à la fabrication des différents éléments du composant électronique proprement dit et un deuxième socle (24) d'épaisseur comprise entre 100 et 300 microns en un matériau moins cassant que le silicium, ledit deuxième socle ayant une épaisseur plus grande que celle du premier socle et une section identique à celle du premier socle et étant fixé de l'autre côté du premier socle (23) ainsi que sur un film (21) qui sert d'élément de fermeture de la cavité.

2. Support de composant électronique selon la revendication 1, caractérisé en ce que le matériau du deuxième socle est du titane.

3. Support de composant électronique selon la revendication 1, caractérisé en ce que le matériau du deuxième socle est du cobalt.

4. Support de composant électronique pour carte d'identification selon la revendication 1, caractérisé en ce que le matériau du deuxième socle est du vanadium.

5. Support de composant électronique selon la revendication 1, caractérisé en ce que le matériau du deuxième socle est une céramique.

6. Support de composant électronique selon la revendication 1, caractérisé en ce que le matériau du deuxième socle est du plastique chargé de fibres de verre.

7. Carte mémoire munie d'une cavité comportant un composant électronique, caractérisé en ce que le composant électronique repose sur un support selon l'une quelconque des revendications précédentes de 1 à 6.

## Claims

1. An electronic component support for a memory card which includes a cavity to house said component, characterized in that the support comprises a first base (23) made of silicon having a thickness of between 50 and 100 microns, one side of which serves as the substrate for the manufacture of different elements of the electronic component proper and a second base (24) having a thickness of between 100 and 300 microns and made of a less brittle material than silicon, the said second base having a greater thickness than the first and an identical cross-section to that of the first and being fixed to the other side of the first base (23) as well as to a film (21) which acts as an element to close the cavity.

2. An electronic component support according to claim 1, characterized in that the material from which the second base is made is titanium.

3. An electronic component support according to claim 1, characterized in that the material from which the second base is made is cobalt.

4. An electronic component support for identification cards according to claim 1, characterized in that the material from which the second base is made is vanadium.

5. An electronic component support according to claim 1, characterized in that the material from which the second base is made is a ceramic.

6. An electronic component support according to claim 1, characterized in that the material from which the second base is made is a plastic comprising fibre-glass.

7. A memory card provided with a cavity containing an electronic component, characterized in that the electronic component is positioned on a support according to any one of the preceding claims 1 to 6.

## Patentansprüche

1. Elektronikbauteilträger für eine Speicherkarte, mit einem Hohlraum zur Aufnahme dieses Bauteils, dadurch gekennzeichnet, daß der Träger einen ersten Sockel aus Silizium (23) einer Dicke zwischen 50 und 100 Mikron aufweist, wovon eine Seite als Basis zur Herstellung der verschiedenen Elemente des eigentlichen Elektronikbauteils dient, und einen zweiten Sockel (24) einer Dicke zwischen 100 und 300 Mikron aus einem weniger brüchigen Material als Silizium aufweist, wobei dieser zweite Sockel eine größere Dicke als der erste Sockel und den gleichen Querschnitt wie der erste Sockel aufweist sowie auf der anderen Seite des ersten Sockels (23) auf einen Film (21) befestigt ist, der als Verschlußelement für den Hohlraum dient.

2. Elektronikbauteilträger nach Anspruch 1, dadurch gekennzeichnet, daß das Material des zweiten Sockels Titan ist.

3. Elektronikbauteilträger nach Anspruch 1, dadurch gekennzeichnet, daß das Material des zweiten Sockels Kobalt ist.

4. Elektronikbauteilträger für eine Identifikationskarte, gemäß Anspruch 1, dadurch gekennzeichnet, daß das Material des zweiten Sockels Vanadium ist.

5. Elektronikbauteilträger nach Anspruch 1, dadurch gekennzeichnet, daß das Material des zweiten Sockels eine Keramik ist.

6. Elektronikbauteilträger nach Anspruch 1, dadurch gekennzeichnet, daß das Material des zweiten Sockels ein mit Glasfasern befrachtetes Plastikmaterial ist.

7. Speicherkarte, die mit einem Hohlraum versehen ist, der ein Elektronikbauteil aufweist, dadurch gekennzeichnet, daß das Elektronikbauteil auf einem Träger nach einem der vorstehenden Ansprüche 1 bis 6 ruht.
